# EUROPÄISCHE PATENTANMELDUNG

(11) **EP 2 079 114 A2**
(43) Veröffentlichungstag der Anmeldung: **15.07.2009**
(21) Anmeldenummer: 09100007.5
(22) Anmeldetag: 05.01.2009
(51) Int. Cl.: H01L 41/053, H01L 41/083, F02M 51/06

(54) **Piezoelektrisches Aktormodul und Brennstoffeinspritzventil**

(30) Priorität: 10.01.2008 DE 102008003839
(71) Anmelder: ROBERT BOSCH GMBH, 70442 Stuttgart (DE)
(72) Erfinder: Dirscherl, Florian, 96049, Bamberg (DE); Schaich, Udo, 70378, Stuttgart (DE)

(57) **Zusammenfassung**

Ein piezoelektrisches Aktormodul (2) für ein Brennstoffeinspritzventil (1) weist einen Aktorkörper (23) auf. Der Aktorkörper (23) umfasst eine Vielzahl von keramischen Schichten (26, 27) und eine Vielzahl von zwischen den keramischen Schichten angeordnete Elektrodenschichten (28, 29). Dabei ist an den Aktorkörper (23) einerseits ein Aktorfuß (24) und andererseits ein Aktorkopf (25) angefügt. Ferner ist ein Aktorhülsenverband (25) vorgesehen, der den Aktorkörper (23) umgibt. Der Aktorhülsenverband (25) weist eine Metallhülse (36) und eine nichtmetallische Hülse (37) auf, die miteinander verbunden sind. Die Metallhülse (36) ist mittels umlaufender Schweißnähte (51, 52) mit dem Aktorfuß (24) und dem Aktorkopf (25) verbunden.

## Beschreibung

### Stand der Technik

Die Erfindung betrifft ein piezoelektrisches Aktormodul für ein Brennstoffeinspritzventil und ein Brennstoffeinspritzventil mit solch einem piezoelektrischen Aktormodul. Speziell betrifft die Erfindung das Gebiet der Injektoren für Brennstoffeinspritzanlagen von luftverdichtenden, selbstzündenden Brennkraftmaschinen.

Aus der DE 101 33 151 A1 ist ein Bauteil mit einem Bauelement und einem das Bauelement umgebenden Gehäuse bekannt. Dabei ist zwischen dem Gehäuse und dem Bauelement ein geringer Abstand vorgesehen, der einen Gießspalt definiert. In diesem Gießspalt ist eine Vergussmasse eingefüllt, die einen vernetzenden Füllstoff enthält. Dabei ist ein relativ hoher Füllstoffgehalt der Vergussmasse vorgegeben, wobei der Füllstoffgehalt bezogen auf das Gesamtgewicht der Vergussmasse zwischen 20 und 90 Gewichtsprozent liegt. Als Vergussmasse können Harze auf der Basis von Siliconen, Polyurethanen und Epoxiden eingesetzt werden, die mit einem Füllstoff aus der Gruppe Siliziumdioxid, Aluminiumoxid, Titandioxid, Bornitrid und Aluminiumnitrid gefüllt sind, um ihre Wärmeleitfähigkeit zu verbessern.

Das aus der DE 101 33 151 A1 bekannte Bauteil hat den Nachteil, dass die Herstellung aufwändig ist. Speziell ist die Vorgabe einer schmalen, gleichmäßigen Gießspalte und deren homogene Befüllung relativ aufwändig. Ferner besteht bei einem solchen Bauteil, bei dem das Bauelement aus einem Piezoaktor gebildet ist, das Problem, dass die Vergussmasse sowohl in Verbindung mit dem Bauelement als auch mit dem Gehäuse steht, so dass im Betrieb bei periodischen Dehnungen des Bauelements Spannungen in der Vergussmasse auftreten, was sich ungünstig auf die Zuverlässigkeit und Funktionsfähigkeit auswirken kann.

### Offenbarung der Erfindung

Das erfindungsgemäße Aktormodul mit den Merkmalen des Anspruchs 1 und das erfindungsgemäße Brennstoffeinspritzventil mit den Merkmalen des Anspruchs 11 haben den Vorteil, dass eine relativ kostengünstige Herstellung ermöglicht ist, wobei ein zuverlässiger Schutz gegenüber Medien gewährleistet ist, und dass insbesondere eine hohe Zuverlässigkeit und Funktionsfähigkeit gewährleistet ist.

Durch die in den Unteransprüchen aufgeführten Maßnahmen sind vorteilhafte Weiterbildungen des im Anspruch 1 angegebenen Aktormoduls und des im Anspruch 11 angegebenen Brennstoffeinspritzventils möglich.

In vorteilhafter Weise umfasst der Aktorhülsenverband zwei oder mehr Hülsen, von denen eine als Metallhülse aus einem Metall oder einer Metalllegierung und eine andere als nichtmetallische Hülse ausgebildet ist. Dies ermöglicht ein gutes Permeationsverhalten, d.h. eine zuverlässige Abdichtung gegenüber umgebende Medien, insbesondere einem Brennstoff. Umgebende Medien, wie beispielsweise Dieselbrennstoff und Biokraftstoffe und deren Additive, können Wasser oder Bestandteile, welche leitfähige Stoffe bilden, aufweisen, so dass es beim Eindringen des Mediums in das piezoelektrische Aktormodul zu einem Kurzschluss zwischen den Elektrodenschichten beziehungsweise an der Aktoroberfläche kommen kann. Ferner kann das eindringende Medium den Aktorkörper oder andere Elemente des piezoelektrischen Aktormoduls durch chemische oder mechanische Einwirkung schädigen. Der Aktorhülsenverband ermöglicht eine vorteilhafte Kombination von Eigenschaften verschiedener Materialien. Speziell kann der Vorteil eines relativ dünnwandig ausgestalteten Aktorhülsenverbands erreicht werden. Dies wirkt sich günstig auf den Platzbedarf aus und ermöglicht auch die Ausgestaltung eines elastischen Aktorhülsenverbandes, beispielsweise wenn der Aktorhülsenverband als wellenförmiger Aktorhülsenverband in Form eines Wellbalges ausgestaltet ist.

In vorteilhafter Weise ist die nichtmetallische Hülse über ihre gesamte Oberfläche mit einer Oberfläche der Metallhülse verbunden. Dadurch werden auch kleine Relativbewegungen zwischen der nichtmetallischen Hülse und der Metallhülse, insbesondere Mikrobewegungen, verhindert, so dass ein zu Undichtigkeit führender Verschleiß zwischen der nichtmetallischen Hülse und der Metallhülse verhindert ist. Speziell ist es vorteilhaft, dass eine Haftfestigkeit zwischen der nichtmetallischen Hülse und der Metallhülse ausreichend groß ist, um eine solche Relativbewegung auch bei gesamtflächig oder großflächig miteinander verbundenen Hülsen zu verhindern.

In vorteilhafter Weise ist die nichtmetallische Hülse ferner durch Laminieren, Vulkanisieren oder Kleben mit der Metallhülse verbunden. Speziell kann auf diese Weise eine aus Kunststoff gebildete nichtmetallische Hülse mit der Metallhülse verbunden sein. Insbesondere kann die nichtmetallische Hülse aus einem Polymer gebildet sein. Die Verbindung der beiden Hülsen miteinander kann bei der Herstellung in einem vorgeschalteten thermischen Prozess oder auch bei einem Umformprozess des Aktorhülsenverbandes, insbesondere direkt während dem Aufblasen zur endgültigen Form unter Hilfe von Druck und Temperatur, erfolgen. Die hierbei eingesetzten Temperaturen werden dabei entsprechend abgestimmt. In vorteilhafter Weise ist die nichtmetallische Hülse an einer innenliegenden Oberfläche der Metallhülse vorgesehen, wobei speziell die Metallhülse als äußerste Hülse und die nichtmetallische Hülse als eine innenliegende Hülse angeordnet sein kann. Dabei ist es ferner vorteilhaft, dass an einem Ende des Aktorhülsenverbands ein Abstandsmaß eingestellt ist, wobei die nichtmetallische Hülse an dem Ende des Aktorhülsenverbands in einer axialen Richtung gegenüber der Metallhülse um das Abstandsmaß zurückgesetzt ist. Dies hat den Vorteil, dass eine Verbindung der Metallhülse mit anderen Elementen, insbesondere einem an den Aktorkörper angefügten Übergangsstück, durch Schweißen oder dgl. ermöglicht ist, so dass eine hochdruckfeste Verbindung der Metallhülse und somit des gesamten Aktorhülsenverbandes an dem Aktormodul ausgebildet ist.

Speziell kann die Metallhülse mittels einer umlaufenden Schweißnaht mit dem Übergangsstück oder dgl. verbunden sein.

Bei der Ausgestaltung des piezoelektrischen Aktormoduls kann ein Zwischenraum zwischen dem Aktorkörper und dem Aktorhülsenverband ausgebildet sein. Dabei ist es vorteilhaft, dass solch ein Zwischenraum mit einem Füllmittel aufgefüllt ist, insbesondere mit einem oder mehreren Polymeren und/oder Kunststoffen ausgegossen ist. Dadurch kann die Abdichtung weiter verbessert und insbesondere eine Stabilisierung des Aktorhülsenverbandes gegenüber dem von der Umgebung her einwirkenden Druck des umgebenden Mediums gewährleistet werden.

### Kurze Beschreibung der Zeichnungen

Ein bevorzugtes Ausführungsbeispiel der Erfindung ist in der nachfolgenden Beschreibung anhand der beigefügten Zeichnungen, in denen sich entsprechende Elemente mit übereinstimmenden Bezugszeichen versehen sind, näher erläutert. Es zeigt:
- Fig. 1: ein Brennstoffeinspritzventil mit einem piezoelektrischen Aktormodul in einer schematischen Schnittdarstellung entsprechend einem Ausführungsbeispiel der Erfindung;
- Fig. 2: den in Fig. 1 gezeigten Aktorhülsenverband während der Herstellung und
- Fig. 3: den in Fig. 2 gezeigten Aktorhülsenverband für das piezoelektrische Aktormodul als hergestelltes Bauteil vor der weiteren Montage.

### Ausführungsformen der Erfindung

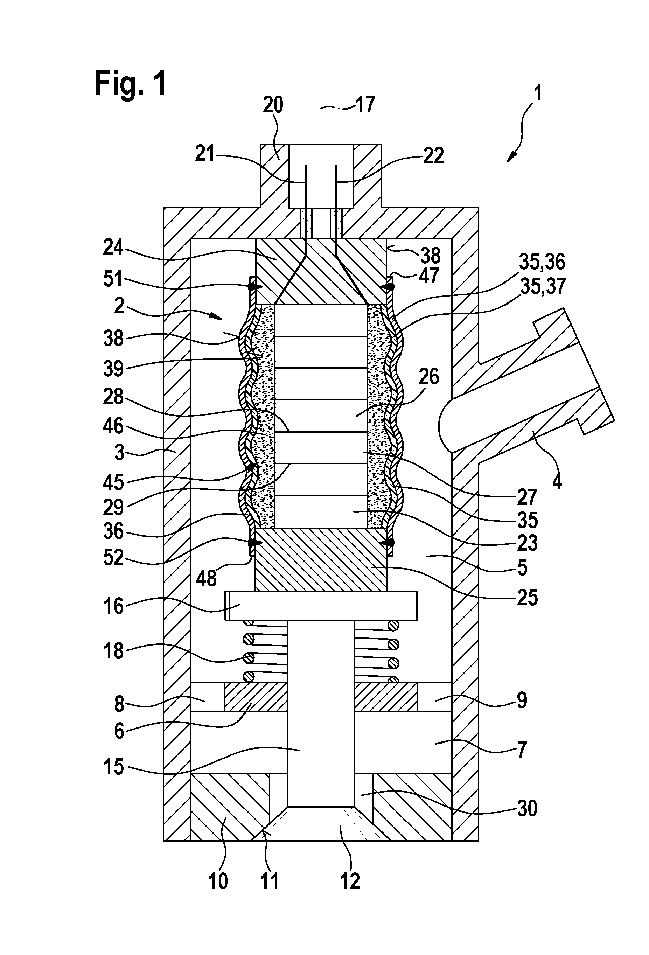

Fig. 1 zeigt ein Brennstoffeinspritzventil 1 mit einem piezoelektrischen Aktormodul 2 entsprechend einem ersten Ausführungsbeispiel der Erfindung. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Das erfindungsgemäße piezoelektrische Aktormodul 2 eignet sich besonders für solch ein Brennstoffeinspritzventil 1 und auch für eine inverse Ansteuerung des piezoelektrischen Aktormoduls 2. Das erfindungsgemäße Brennstoffeinspritzventil 1 und das erfindungsgemäße piezoelektrische Aktormodul 2 eignen sich jedoch auch für andere Anwendungsfälle, wo Kraft-, Weggesteuerte Elemente zum Einsatz kommen.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um das Brennstoffeinspritzventil 1 über ein Common-Rail oder direkt mit einer Hochdruckpumpe zu verbinden. Über den Brennstoffeinlassstutzen 4 kann dann Brennstoff in einen im Inneren des Ventilgehäuses 3 vorgesehenen Aktorraum 5 eingeleitet werden, so dass sich im Betrieb des Brennstoffeinspritzventils 1 Brennstoff in dem Aktorraum 5, in dem auch das piezoelektrische Aktormodul 2 vorgesehen ist, befindet. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind dabei Durchlassöffnungen 8, 9 ausgestaltet, um den über den Brennstoffeinlassstutzen 4 in den Aktorraum 5 geführten Brennstoff in den Brennstoffraum 7 zu leiten.

Das Ventilgehäuse 3 ist mit einem Ventilsitzkörper 10 verbunden, an dem eine Ventilsitzfläche 11 ausgebildet ist. Die Ventilsitzfläche 11 wirkt mit einem Ventilschließkörper 12 zu einem Dichtsitz zusammen. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Dabei ist die Ventilnadel 15 durch das Gehäuseteil 6 entlang einer Achse 17 des Brennstoffeinspritzventils 1 geführt. Ein Federelement 18, das einerseits an dem Gehäuseteil 6 und andererseits an der Druckplatte 16 anliegt, beaufschlagt den piezoelektrischen Aktor 2 mit einer Vorspannkraft, wobei durch die Beaufschlagung außerdem die Ventilnadel 15 mittels der Druckplatte 16 betätigt wird, so dass der zwischen dem Ventilschließkörper 12 und der Ventilsitzfläche 11 gebildete Dichtsitz geschlossen ist.

Außerdem weist das Ventilgehäuse 3 ein Anschlusselement 20 auf, um das Anschließen einer elektrischen Zuleitung an das Brennstoffeinspritzventil 1 zu ermöglichen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 23 des Aktormoduls 2 angefügten Aktorfuß 24 an den Aktorkörper 23 geführt. An den Aktorkörper 23 des piezoelektrischen Aktormoduls 2 ist ferner ein Aktorkopf 25 angefügt, über den der Aktorkörper 23 entgegen der Kraft des Federelements 18 auf die Druckplatte 16 einwirkt. Das piezoelektrische Aktormodul 2 weist in dem dargestellten Ausführungsbeispiel den Aktorkörper 23, den Aktorfuß 24 und den Aktorkopf 25 auf. Der Aktorfuß 24 und der Aktorkopf stellen jeweils ein an den Aktorkörper 23 angefügtes Übergangsstück dar.

Der Aktorkörper 23 des piezoelektrischen Aktormoduls 2 weist eine Vielzahl von keramischen Schichten 26, 27 und eine Vielzahl von zwischen den keramischen Schichten 26, 27 angeordneten Elektrodenschichten 28, 29 auf. Dabei sind in der Fig. 1 zur Vereinfachung der Darstellung nur die keramischen Schichten 26, 27 sowie die Elektrodenschichten 28, 29 gekennzeichnet. Die Elektrodenschichten 28, 29 sind abwechselnd mit der elektrischen Leitung 21 und der elektrischen Leitung 22 verbunden, so dass alternierend positive und negative Elektroden zwischen den keramischen Schichten 26, 27 vorgesehen sind.

Über die elektrischen Leitungen 21, 22 kann der Aktorkörper 23 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 30 und den geöffneten Dichtsitz. Beim Entladen des Aktorkörpers 23 zieht sich dieser wieder zusammen, so dass der zwischen dem Ventilschließkörper 12 und der Ventilsitzfläche 11 ausgebildete Dichtsitz wieder geschlossen ist.

Die Verbindung der elektrischen Leitungen 21, 22 mit den Elektrodenschichten 28, 29 kann durch innenliegende Elektrodenanbindungen erfolgen. Es können allerdings auch außenliegende Elektrodenanbindungen vorgesehen sein. Der Aktorkörper 23 ist zwischen dem Aktorkopf 25 und dem Aktorfuß 24 angeordnet.

Das piezoelektrische Aktormodul 2 weist einen Aktorhülsenverband 35 auf. Der Aktorhülsenverband 35 weist zwei Hülsen 36, 37 auf. Der Aktorhülsenverband 35 kann aber auch mehr als zwei Hülsen 36, 37 aufweisen. Der Aktorhülsenverband 35 weist in diesem Ausführungsbeispiel eine außenliegende Metallhülse 36 und eine innenliegende nichtmetallische Hülse 37 auf. Dabei ist die Metallhülse 36 aus einem Metall oder einer Metalllegierung gebildet. Die nichtmetallische Hülse 37 ist vorzugsweise aus einem Kunststoff, beispielsweise aus einem Polymer, gebildet. Die nichtmetallische Hülse 37 weist eine außenliegende Oberfläche 38 auf, an der die nichtmetallische Hülse 37 mit einer innenliegenden Oberfläche 39 verbunden ist. Die außenliegende Oberfläche 38 der nichtmetallischen Hülse 37 ist dabei vorzugsweise großflächig oder vollflächig mit der innenliegenden Oberfläche 39 der Metallhülse 36 verbunden. Die Verbindung kann durch Laminieren, Vulkanisieren oder Kleben erfolgen.

Der Aktorhülsenverband 35 ist als wellenförmiger Aktorhülsenverband 35 in Form eines Wellbalges ausgestaltet, so dass eine gewisse Elastizität des Aktorhülsenverbandes 35 in einer axialen Richtung, d.h. entlang der Achse 17, gegeben ist. Dies wirkt sich günstig auf die Funktionsfähigkeit des Aktorkörpers 23 im Betrieb des Brennstoffeinspritzventils 1 aus.

Durch die mehrlagige oder mehrschichtige Ausgestaltung des Aktorhülsenverbandes 35 mit den Hülsen 36, 37 können in vorteilhafter Weise die Eigenschaften unterschiedlicher Materialien miteinander kombiniert werden. Dadurch ergibt sich insbesondere ein günstiges Permeationsverhalten, d.h. eine zuverlässige Abdichtung des Aktorkörpers 23 und gegebenenfalls weitere Elemente des piezoelektrischen Aktormoduls 2 gegenüber dem im Aktorraum 5 vorgesehenen, unter hohem Druck stehenden Brennstoff. Speziell ergibt sich bei einem Dieselbrennstoff eine zuverlässige Abdichtung gegenüber das enthaltene Wasser beziehungsweise Bestandteilen, welche leitfähige Stoffe bilden, so dass Kurzschlüsse zwischen den Elektrodenschichten 28, 29 verhindert sind. Außerdem ist eine chemische oder mechanische Beeinträchtigung des Aktorkörpers 23 durch den Brennstoff verhindert.

In diesem Ausführungsbeispiel ist zwischen dem Aktorhülsenverband 35 und dem Aktorkörper 23 ein Zwischenraum 45 ausgebildet, der mit einem Füllmittel 46 aufgefüllt ist. Das Füllmittel 46 kann dabei die Dichtwirkung gegenüber der Umgebung, d.h. dem Aktorraum 5, weiter verbessern. Außerdem kann durch das in dem Zwischenraum 45 vorgesehene Füllmittel 46 eine Abstützung des Aktorhülsenverbandes 35 erfolgen, um die hohen Kräfte aufzunehmen, die durch den Druck des Brennstoffes im Aktorraum 5 auf den Aktorhülsenverband 35 einwirken.

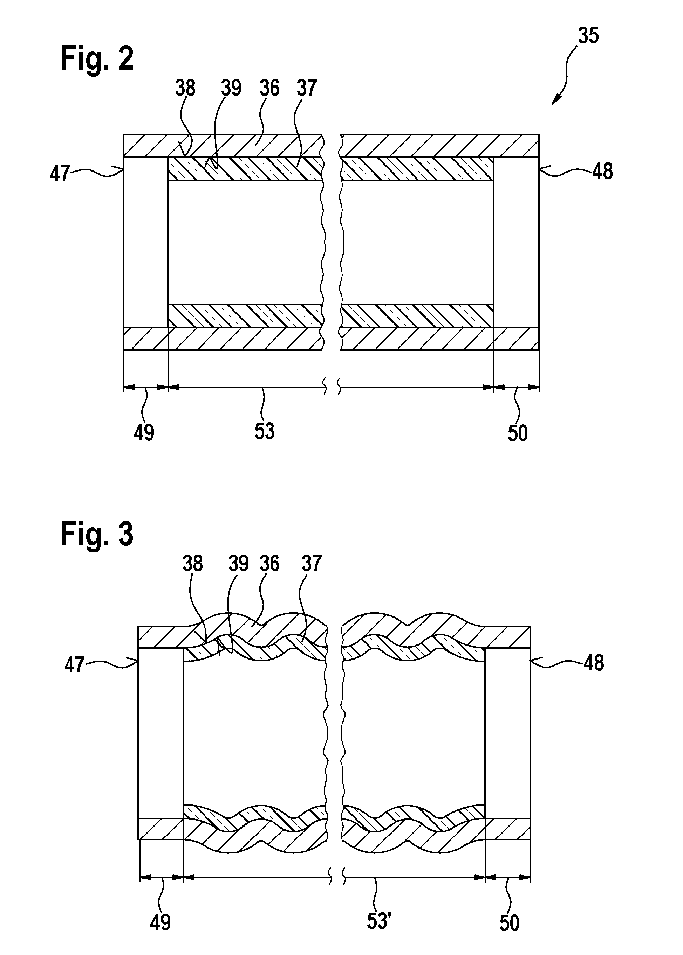

Der Aktorhülsenverband 35 hat Enden 47, 48. Dabei ist an dem Ende 47 ein Abstandsmaß 49 eingestellt, wobei die nichtmetallische Hülse 37 an dem Ende 47 des Aktorhülsenverbandes 35 in axialer Richtung gegenüber der Metallhülse 36 um das Abstandsmaß 49 zurückgesetzt ist, wie es im Detail anhand der Figuren 2 und 3 beschrieben ist. Entsprechend ist an dem anderen Ende 48 des Aktorhülsenverbandes 35 ein Abstandsmaß 50 eingestellt, wobei die nichtmetallische Hülse 37 an dem Ende 48 des Aktorhülsenverbandes 35 in axialer Richtung gegenüber der Metallhülse 36 um das Abstandsmaß 50 zurückgesetzt ist, wie es ebenfalls anhand der Figuren 2 und 3 im Detail beschrieben ist.

In diesem Ausführungsbeispiel sind die Übergangsstücke 24, 25, d.h. der Aktorfuß 24 und der Aktorkopf 25, an den Aktorkörper 23 angefügt. Durch die Ausgestaltung des Aktorhülsenverbandes 35, bei dem die nichtmetallische Hülse 37 an den beiden Enden 47, 48 zurückgesetzt ist, kann die Metallhülse 36 durch eine umlaufende Schweißnaht 51 direkt mit dem Aktorfuß 24 verbunden werden und die Metallhülse 36 kann durch eine umlaufende Schweißnaht 52 direkt mit dem Aktorkopf 25 verbunden werden. Somit ist an den beiden Enden 47, 48 des Aktorhülsenverbandes 35 eine zuverlässige, insbesondere hochdruckfeste, Verbindung zwischen der Metallhülse 36 und somit dem Aktorhülsenverband 35 und den Übergangsstücken 24, 25 ausgebildet. Somit kann durch den Aktorhülsenverband 35 eine zuverlässige Abdichtung des Aktorkörpers 23 gegenüber hohen Drucken, beispielsweise von ca. 200 MPa (2000 bar) oder mehr erzielt werden, wobei durch die Ausgestaltung des Aktorhülsenverbandes 35 mit zwei oder mehr Hülsen 36, 37 eine optimierte, d.h. relativ kleine Wandstärke, erreicht werden kann. Beispielsweise kann in Abhängigkeit vom jeweiligen Anwendungsfall eine Wandstärke von ca. 30 µm erreicht werden. Bei der Ausgestaltung des Aktorhülsenverbandes 35 in Form eines Wellbalges ist die Auslegung der Wellenhöhe und Wellenzahl unter Berücksichtigung des möglicherweise unterschiedlichen Temperaturgangs der Hülsen 36, 37 vorzunehmen. Dabei ist eine Maßgröße die Elastizität der Metallhülse 36, da ein Reißen der Metallhülse 36 im Betrieb im Hinblick auf die erforderliche Dichtheit zu verhindern ist.

Fig. 2 zeigt den in Fig. 1 dargestellten Aktorhülsenverband 35 während der Herstellung. Die Metallhülse 36 und die nichtmetallische Hülse 37 können in Form eines Schlauches aus einem metallischen bzw. polymeren Werkstoff gebildet sein. Dabei ist eine Länge 53 der nichtmetallischen Hülse 37 kürzer gewählt als eine Länge der Metallhülse 36, die sich aus der Länge 53 der nichtmetallischen Hülse 37 und den Abstandsmaßen 49, 50 ergibt. Das Abstandsmaß 49 und das Abstandsmaß 50 sind jeweils so eingestellt, dass die Metallhülse 36 an dem Ende 47 bei der späteren Montage mit dem Aktorfuß 24 und an dem Ende 48 mit dem Aktorkopf 25 verschweißt werden kann. Die Länge 53 der nichtmetallischen Hülse 47, die auch in die Ermittlung der Länge der Metallhülse 36 eingeht, ist so vorgegeben, dass die endgültige Ausgestaltung, wie sie in der Fig. 3 gezeigt ist, an die in axialer Richtung betrachtete Einbaulänge des Aktorkörpers 23 angepasst ist. Die Verbindung der Metallhülse 36 mit der nichtmetallischen Hülse 37, d.h. die Verbindung der beiden Oberflächen 38, 39 kann bereits in dem in der Fig. 2 dargestellten Zustand erfolgen, in dem der Aktorhülsenverband 35 noch keine Wellbalgstruktur aufweist. Die Verbindung kann aber auch während des Prozesses zur Ausgestaltung der Wellbalgstruktur erfolgen.

Fig. 3 zeigt den in Fig. 2 dargestellten Aktorhülsenverband 35 im hergestellten Zustand vor der Montage in das piezoelektrische Aktormodul 2. Durch die Ausbildung des Aktorhülsenverbandes 35 als wellenförmiger Aktorhülsenverband 35 hat sich die Länge 53 der nichtmetallischen Hülse 37, wie sie in der Fig. 2 dargestellt ist, auf die Länge 53' verkürzt. Somit ist auch die Gesamtlänge des Aktorhülsenverbandes 35, die sich aus der Länge 53' und den Abstandsmaßen 49, 50 zusammensetzt, verringert. Bei der Ausformung des Aktorhülsenverbandes 35 bleiben die Abstandsmaße 49, 50 an den Enden 47, 48 des Aktorhülsenverbandes 35 aber vorzugsweise zumindest im Wesentlichen unverändert, wobei ferner vorzugsweise keine Umformung der Metallhülse 36 im Bereich der Enden 47, 48 über die Abstandsmaße 49, 50 erfolgt, so dass eine zuverlässige Befestigung der Metallhülse 36 und somit des Aktorhülsenverbandes 35 an den Übergangsstücken 24, 25 des piezoelektrischen Aktormoduls 2 ermöglicht ist.

Somit wird in vorteilhafter Weise eine kostengünstige und montagefreundliche Ausgestaltung eines aus Kunststoff und Metall bestehenden Aktorhülsenverbandes 35, der ein Schutzschichtsystem darstellt, für das piezoelektrische Aktormodul 2 ermöglicht. Durch die Wellenform in der Mantelfläche des Aktorhülsenverbandes 35 kann die Hub- und Temperaturdehnung des piezoelektrischen Aktormoduls 2 ausgeglichen werden, ohne dass die Dehnfähigkeit der gegebenenfalls als Metallfolie ausgestalteten Metallhülse 36 überschritten wird. Ferner ist die Herstellung eines prozesssicheren Anliefersystems für den Arbeitsgang Montage und damit die Vermeidung von nicht prozesssicheren Wickelprozessen, geöffneten Beschichtungsenden und damit verbundener Permeationsmöglichkeit möglich. Außerdem können durch den Aktorhülsenverband 35 dünnwandige Wellbalgschutzhülsen im Mikrometerbereich hergestellt werden, so dass ein größerer Durchfluss des Brennstoffes und/oder eine engere Gestaltung des Aktorraumes 5 und somit ein reduzierter Durchmesser des Brennstoffeinspritzventils 1 möglich ist. Ferner können durch ein größeres verbleibendes Volumen im Aktorraum 5 in Bezug auf das piezoelektrische Aktormodul 2 geringere Druckschwankungen im System erreicht und damit ein optimiertes Einspritzkennfeld erzeugt werden.

Die Erfindung ist nicht auf das beschriebene Ausführungsbeispiel beschränkt.

## Patentansprüche

1. Piezoelektrisches Aktormodul (2), insbesondere Aktormodul für Brennstoffeinspritzventile, mit einem Aktorkörper (23), der eine Vielzahl von keramischen Schichten (26, 27) und eine Vielzahl von zwischen den keramischen Schichten (26, 27) angeordneten Elektrodenschichten (28, 29) aufweist,
**dadurch gekennzeichnet,**
**dass** ein Aktorhülsenverband (35) vorgesehen ist, der den Aktorkörper (23) umgibt, und dass der Aktorhülsenverband (25) eine Metallhülse (36) und zumindest eine nichtmetallische Hülse (37), die zumindest mittelbar mit der Metallhülse (36) verbunden ist, aufweist.

2. Piezoelektrisches Aktormodul nach Anspruch 1,
**dadurch gekennzeichnet, dass** eine Oberfläche (38) der nichtmetallischen Hülse (37) zumindest im Wesentlichen über die gesamte Oberfläche (38) der nichtmetallischen Hülse (37) mit einer Oberfläche (39) der Metallhülse (36) verbunden ist.

3. Piezoelektrisches Aktormodul nach Anspruch 1 oder 2,
**dadurch gekennzeichnet,**
**dass** die nichtmetallische Hülse (37) durch Laminieren, Vulkanisieren oder Kleben mit der Metallhülse (36) verbunden ist.

4. Piezoelektrisches Aktormodul nach einem der Ansprüche 1 bis 3,
**dadurch gekennzeichnet, dass** die nichtmetallische Hülse (37) zumindest im Wesentlichen aus zumindest einem Kunststoff gebildet ist.

5. Piezoelektrisches Aktormodul nach Anspruch 4,
**dadurch gekennzeichnet,**
**dass** die nichtmetallische Hülse (37) zumindest im Wesentlichen aus einem Polymer gebildet ist.

6. Piezoelektrisches Aktormodul nach einem der Ansprüche 1 bis 5,
**dadurch gekennzeichnet, dass** die nichtmetallische Hülse (37) an einer innenliegenden Oberfläche (39) der Metallhülse (36) vorgesehen ist.

7. Piezoelektrisches Aktormodul nach einem der Ansprüche 1 bis 6,
**dadurch gekennzeichnet, dass** an zumindest einem Ende (47, 48) des Aktorhülsenverbands (35) ein Abstandsmaß (49, 50) eingestellt ist, wobei die nichtmetallische Hülse (37) an dem Ende (47, 48) des Aktorhülsenverbands (35) gegenüber der Metallhülse (36) um das Abstandsmaß (49, 50) zurückgesetzt ist.

8. Piezoelektrisches Aktormodul nach Anspruch 7,
**dadurch gekennzeichnet, dass** zumindest ein an den Aktorkörper (23) angefügtes Übergangsstück (24, 25) vorgesehen ist, dass die Metallhülse (36) das Übergangsstück (24, 25) zumindest teilweise umgibt und dass die Metallhülse (36) mit dem Übergangsstück (24, 25) verbunden ist.

9. Piezoelektrisches Aktormodul nach Anspruch 8,
**dadurch gekennzeichnet,**
**dass** die Metallhülse (36) mittels zumindest einer umlaufenden Schweißnaht (51, 52) mit dem Übergangsstück (24, 25) verbunden ist.

10. Brennstoffeinspritzventil nach einem der Ansprüche 1 bis 9,
**dadurch gekennzeichnet, dass** der Aktorhülsenverband (35) zumindest abschnittsweise wellenförmig ausgestaltet ist.

11. Piezoelektrisches Aktormodul nach einem der Ansprüche 1 bis 9,
**dadurch gekennzeichnet,**
**dass** ein zwischen dem Aktorkörper (23) und dem Aktorhülsenverband (35) ausgebildeter Zwischenraum (45) zumindest teilweise mit zumindest einem Füllmittel (46) aufgefüllt ist.

12. Brennstoffeinspritzventil (1), insbesondere Injektor für Brennstoffeinspritzanlagen von luftverdichtenden, selbstzündenden Brennkraftmaschinen, mit einem piezoelektrischen Aktormodul (2) nach einem der Ansprüche 1 bis 10 und einem von dem Aktormodul (2) zumindest mittelbar betätigbaren Ventilschließkörper (12), der mit einer Ventilsitzfläche (11) zu einem Dichtsitz zusammenwirkt, wobei das Aktormodul (2) in einem Aktorraum (5) angeordnet ist, in dem sich im Betrieb unter hohem Druck stehender Brennstoff befindet.
